Europäisches Patentamt

European Patent Office

Office européen des brevets

(11) Publication number: **0 053 028**
**B1**

## EUROPEAN PATENT SPECIFICATION

(45) Date of publication of patent specification: **03.07.85**

(21) Application number: **81305517.5**

(22) Date of filing: **23.11.81**

(51) Int. Cl.⁴: **H 04 Q 3/52,** H 03 F 3/08, H 03 K 17/78

(54) Semiconductor switch.

(30) Priority: **24.11.80 US 209956**

(43) Date of publication of application:
**02.06.82 Bulletin 82/22**

(45) Publication of the grant of the patent:
**03.07.85 Bulletin 85/27**

(84) Designated Contracting States:
**DE FR GB IT NL SE**

(56) References cited:
**DE-A-1 562 059**
**DE-A-2 446 302**
**DE-C-1 299 709**
**GB-A-1 518 258**
**US-A-3 731 116**
**US-A-4 286 171**

**IRRR JOURNAL OF QUANTUM ELECTRONICS Vol. QE-16, Nr. 3, March 1980, New York R.I. MacDonald et al. "Switching With Photodiodes" pages 289 to 295**

**The file contains technical information submitted after the application was filed and not included in this specification**

(73) Proprietor: **Canadian Patents and Development Limited**
**275 Slater Street**
**Ottawa Ontario, K1A OR3 (CA)**

(72) Inventor: **Hara, Elmer H.**
**51 Reany Crescent**
**Kanata Ontario (CA)**
Inventor: **MacDonald, R. Ian**
**51 Pooler Avenue**
**Ottawa Ontario (CA)**
Inventor: **Hum, Robert S.H.**
**27 Chinook Crescent**
**Ottawa Ontario (CA)**
Inventor: **Kawasaki, Brian S.**
**R.R, No. 2**
**Carleton Place Ontario (CA)**

(74) Representative: **Pike, Harold John et al**
**Abel & Imray Northumberland House 303-306**
**High Holborn**
**London, WC1V 7LH (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The invention is directed to an electronic switch and in particular to an opto-electronic semiconductor switch.

The need for an electronic switch which has a transmission bandwidth in excess of 100 MHz and an isolation of better than 70 dB is necessary for the successful implementation of a broadband communications service to subscribers. Fast-acting, reliable broadband switches are also required for communications satellites.

Coaxial switches can have an isolation of 60 dB or better over a frequency range of DC to 18 GHz, however their size is large compared to semiconductor switches and therefore these switches would not be practical in switching arrays. The RF PIN diode switch of the type described in the Hewlett Packard Application Note 929 is very fast and has isolation in the order of 50 dB. However, the current required to maintain the "off" state of a PIN diode switch is of the order of 10 mA which is high for crosspoint switches matrices where most of the crosspoint switches are normally in the "off" state.

Another switch, the "Optoelectronic Cross-Point Switch" described in U.S. Patent Specification No. 4,286,171, by Elmer H. Hara and R. Ian MacDonald, has a broad bandwidth and a high isolation factor, however, a significant amount of power is consumed maintaining the switch in the "off" state.

U.S. Patent Specification No. 3,731,116 describes a field effect transistor for connecting and disconnecting an electrical signal source with an output load. The gate of the field effect transistor is used as the control point to turn the transistor on and off. The specification is concerned only with the avoidance of cross modulation by an input signal of sufficient positive amplitude to turn on the transistor monentarily.

An article by McDonald and Hara in the IEE Journal of Quantum Electronics, Volume QE—16 No. 3, March 1980 at pages 289—295 describes the concept of opto-electronic switching and its physical basis in photo-diodes. An intensity modulated light beam is distributed to an array of photo-diode receptors. Each of the receptors is provided with a load resistor that is connected to one of the electrical output lines to which it may be desired to transfer the optical input signal. When a photo-diode of the array is reverse biassed it is sensitive to the optical signal and, in effect, a signal path is established between the input signal and an output line. When a photo-diode is forward biassed its photosensitivity is greatly reduced and the signal path is interrupted.

It is an essential feature of the use of photo-diodes that it is essential to apply a forward bias to the photo-diode to reduce its response to an applied optical signal. Such photo-diodes are depletion layer devices whose reverse currents are altered due to the adsorption of light in or near the depletion layer. Such devices are essentially different from photo-conductive devices in which there is no device polarity and therefore no analogous way of reducing the photosensitivity. Moreover, as has been stated above, a significant amount of power is consumed in maintaining the photo-diodes in the "off" state.

U.K. Specification No. 1,518,258 describes an opto-coupler using a field effect transistor. By applying a suitable bias between the gate and channel of a field effect transistor, the resultant leakage current between channel and gate can be utilised to control the state of the channel. A light emitting diode is used to irradiate the gate and this results in changes in the gate leakage current. An opto-coupler is not capable of performing a switching action and is designed merely to allow an input to control the state of the output.

It is therefore an object of this invention to provide an electronic switch having a broad transmission bandwidth, a high isolation factor and a low electrical power comsumption when maintained in the "off " state.

According to the present invention an opto-electronic switch comprises a photo-conductive detector and voltage means connected to the photo-conductive detector for applying a non-zero bias voltage to the detector to render the latter responsive to an optical signal incident upon the detector and a substanially zero bias voltage to render the detector non-responsive to such optical signal.

In one embodiment of the invention the detector is a photo-sensitive field effect transistor, the voltage means being such that it varies the potential difference between the source and drain of the transistor to switch the latter between the responsive and non-responsive states.

Means may be provided for directing the optical signal on to the channel of the photo-sensitive field effect transistor.

The voltage means may apply a voltage source at one of two predetermined levels (OFF, ON) between the source and drain of the photo-sensitive field effect transistor, the lower voltage level (OFF) rendering the photo-sensitive field effect transistor non-responsive to the optical signal and the higher voltage level (ON) rendering the photo-sensitive field effect transistor responsive to the optical signal.

The photo-sensitive field effect transistor may be a GaAs photo-sensitive field effect transistor.

The voltage means may include a voltage source connected to the photo-sensitive field effect transistor and a semi-conductor switch connected across the voltage source and ground.

Alternatively, the voltage means may include a semi-conductor switch and a voltage source connected in series with the source and drain of the photo-sensitive field effect transistor.

In the drawings:

Figure 1 illustrates an optoelectronic switch embodying the present invention,

Figure 2 is a plot of the resistance of a typical FET,

Figures 3 or 4 illustrate the isolation obtained by the optoelectronic switch shown in Figure 1, and,

Figures 5 and 6 illustrate voltage circuits for the optoelectronic switch.

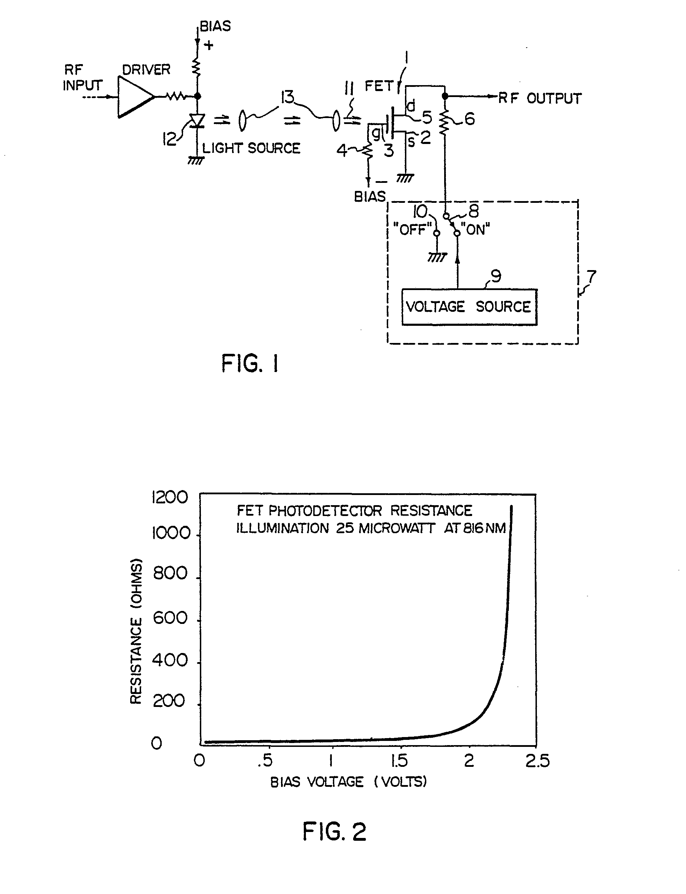

The optoelectronic switch shown in Figure 1 comprises a photoconductive detector 1 which may be a photosensitive FET such as a GaAs FET of the type described in the publication "The OPFET: A new High Speed Optical Detector" by J. C. Gammel et al; International Electron Devices Meeting: IEEE, Washington, D.C., December 4—6, 1978; pages 120 to 123. The source 2 of the FET 1 is grounded, the gate 3 is connected through a resistor 4 to a negative bias and the drain 5 is connected through a load resistor 6 to a voltage circuit 7 which provides a positive voltage to the drain 5 when it is desired to have the FET 1 respond to an optical signal. To this end, the voltage circuit 7 includes a switch 8 which will selectively connect the drain 5 to a voltage source 9 or to a ground terminal 10, or again the drain 5 may be left open-circuited. When the drain 5 is connected to the positive voltage source 9, the FET 1 is conductive, when it is connected to ground 10 or left open-circuited, the FET 1 is nonconductive.

This optoelectronic switch will demodulate an optical signal 11 coupled to the FET 1 in the manner described in the publication referred to above. The modulated optical signal 11 may be obtained by driving an RF input signal through a light source 12 such as a light emitting diode. The modulated optical signal 11 is directed to the FET 1 by a lens system 13 or by other suitable means such as an optical fibre waveguide. The optoelectronic switch is "on" when the potential difference between source 2 and drain 5 is high. The RF signal is recovered by photodetecting the output signal, it is also amplified and may be detected as an RF as FET 1 impedance is altered by the bias and the photodetection efficiency therefore is reduced.

The impedance of FET 1 depends on the voltage applied between the source 2 and drain 5. Because the current through the FET reaches a saturation value as this voltage is increased, the impedance of the FET 1 becomes larger near the saturation voltage by comparison with its impedance for lower bias voltages, as can be seen in Figure 2 which is a plot of the resistance of a typical FET device as a function of source-drain bias voltage. When the impedance is near the saturation value, any photogenerated charge in the FET can be more efficiently transferred into an external circuit connected across the load resistor 6 than when the impedance is small. The change in FET impedance with bias accounts for at least some of the switching action.

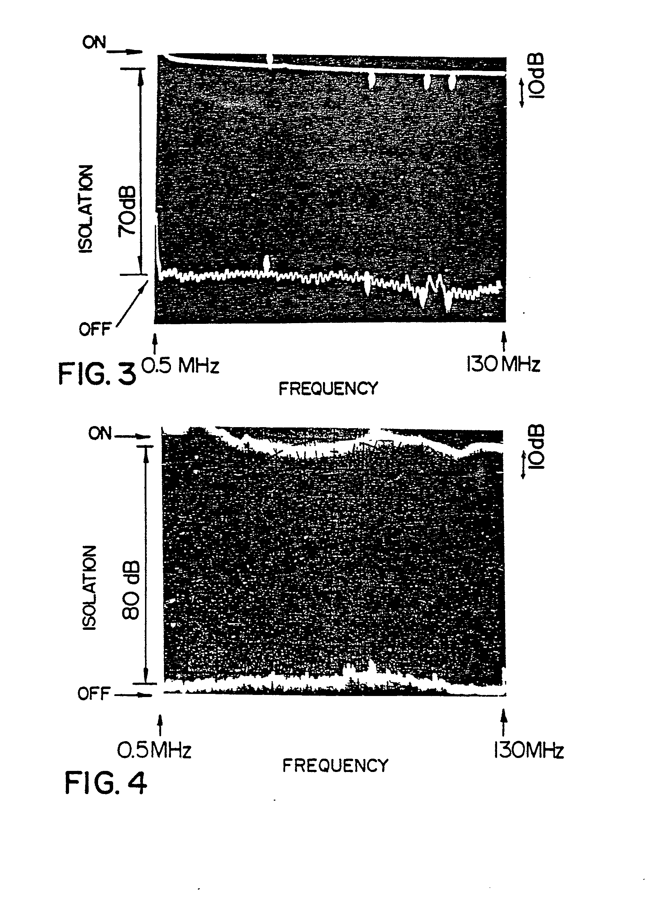

As illustrated in Figure 3, the optoelectronic switch described in Figure 1 provides an isolation of over 60 dB over a frequency range of 10 MHz to 130 MHz when the drain 5 is grounded. If the drain 5 is left open circuited, an isolation of over 70 dB is obtained over a frequency range of 10 MHz to 130 MHz as shown in Figure 4.

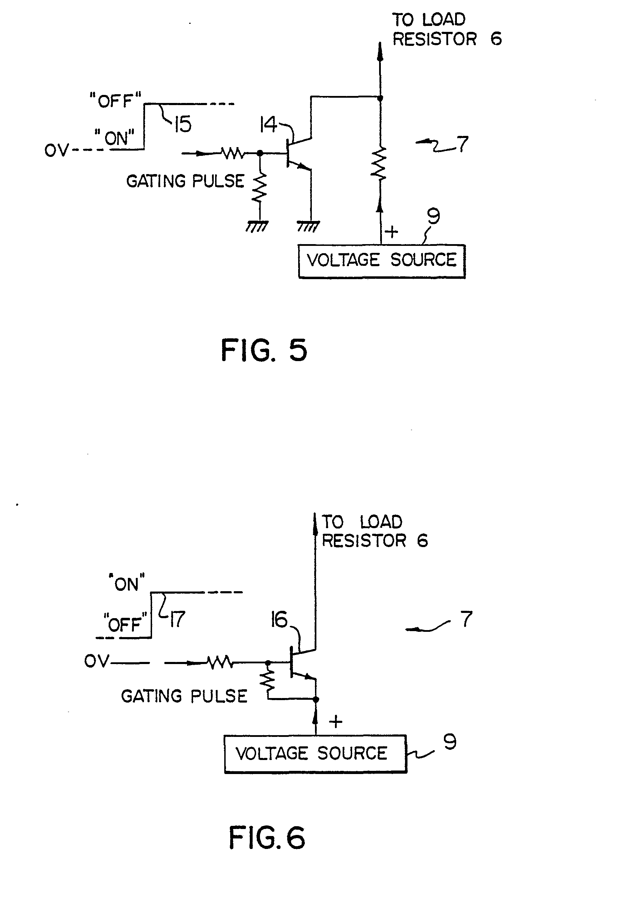

Figures 5 and 6 illustrate various alternative switching circuits for switching the bias voltage to the drain 5 of FET 1. In Figure 5, a transistor 14 is connected across the voltage source 9 to ground 10, such that when transistor 14 is non-conducting, the voltage from source 9 is applied to the FET 1 and the optoelectronic switch is "on". The optoelectronic switch is turned "off" by applying a positive pulse 15 to the transistor 14, rendering it conductive and grounding the FET drain 5.

In Figure 6, a transistor 16 is connected between the drain 5 and the voltage source 9. The transistor 16 when non-conducting maintains the drain 5 at an open circuit. When a pulse 17 is applied to transistor 16, it conducts and connects the drain 5 to the source 9, switching "on" the optoelectronic switch.

The basic concept of the optoelectronic switch described above is that of operating a field effect transistor as an analogue switch with an analogue signal applied to the field effect transistor and switching the latter by controlling its drain-to-source potential difference.

That concept has application to other forms of switch than the optoelectronic switch described above. Inputs other than optical inputs can be switched by applying the input to the gate electrode of a field effect transistor which may be the junction type and switching the latter by controlling its drain-to-source potential difference, for example by using any of the voltage control circuits described above.

Such switches retain the advantage of zero power consumption to maintain the switch in its "off" condition.

**Claims**

1. An opto-electronic switch characterised in that the switch comprises a photo-conductive detector (1) and in that voltage means (7) are connected to the photo-conductive detector (1) for applying a non-zero bias voltage to the detector to render the latter responsive to an optical signal incident upon the detector and a substantially zero bias voltage to render the detector non-responsive to such optical signal.

2. An opto-electronic switch as claimed in claim 1 characterised in that the photo-conductive detector is a photo-sensitive field effect transistor (1) and in that the voltage means (7) is such that it changes the voltage bias between the source (2) and drain (5) of the transistor (1) to switch the transistor between the responsive and non-responsive states.

3. An opto-electronic switch as claimed in claim 2 characterised in that means (13) are provided for directing the optical signal on to the channel of the transistor.

4. An opto-electronic switch as claimed in claim 2 or 3 in which the voltage means (17) applies a voltage source at one of two predetermined different levels (OFF ON) between the source and drain of the transistor, the substantially zero level (OFF) rendering the transistor non-responsive to an optical signal and the non-zero voltage level (ON) rendering the transistor responsive to an optical signal.

5. An opto-electronic switch as claimed in any one of the preceding claims characterised in that the detector is a GaAs field effect transistor.

6. An opto-electronic switch as claimed in any one of the preceding claims characterised in that the voltage means includes a voltage source (9) connected to the detector and semi-conductor switch (14) connected across the voltage source and ground.

7. An opto-electronic switch as claimed in any one of claims 2-5 characterised in that the voltage means (7) is a semi-conductor switch (16) and a voltage source (9) is connected in series with the source and drain of the transistor (1).

## Patentansprüche

1. Ein opto-elektronischer Schalter, dadurch gekennzeichnet, daß der Schalter einen photo-leitenden Detektor (1) umfaßt und daß Spannungsmittel (7) an den photo-leitenden Detektor (1) angeschlossen sind zum Anlegen einer von Null verschiedenen Vorspannung an den Detektor, um den letzteren auf ein auf den Detektor auftreffendes optisches Signal ansprechend zu machen, und einer im wesentlichen bei Null liegenden Vorspannung, um den Detektor auf ein solches optisches Signal nicht ansprechend zu machen.

2. Ein opto-elektronischer Schalter nach Anspruch 1, dadurch gekennzeichnet, daß der photo-leitende Detektor ein photo-empfindlicher Feldeffekttransistor (1) ist und daß die Spannungsmittel (7) derart sind, daß sie die Vorspannung zwischen Source (2) und Drain (5) des Transistors (1) ändern, um den Transistor zwischen dem ansprechenden und dem nichtansprechenden Zustand umzuschalten.

3. Ein opto-elektronischer Schalter nach Anspruch 2, dadurch gekennzeichnet, daß Mittel (13) vorgesehen sind für das Richten des optischen Signals auf den Kanal des Transistors.

4. Ein opto-elektronischer Schalter nach Anspruch 2 oder 3, bei welchem die Spannungsmittel (7) eine Spannungsquelle en einen von zwei vorgegebenen unterschiedlichen Pegeln (AUS EIN) zwischen Source und Drain des Transistors legen, wobei der im wesentlichen bei Null liegende Pegel (AUS) den Transistor auf ein optisches Signal nicht ansprechend macht und der von Null abweichende Spannungspegel (EIN) den Transistor auf ein optisches Signal ansprechend macht.

5. Ein opto-elektronischer Schalter nach einem der vorangehenden Ansprüche, dadurch gekennzeichnet, daß der Detektor ein GaAs Feldeffekttransistor ist.

6. Ein opto-elektronischer Schalter nach einem der vorangehenden Ansprüche, dadurch gekennzeichnet, daß die Spannungsmittel eine Spannungsquelle (9) umfassen, angeschlossen an den Detektor und einen Halbleiterschalter (14), angeschlossen über der Spannungsquelle und Masse.

7. Ein opto-elektronischer Schalter nach einem der Ansprüche 2 bis 5, dadurch gekennzeichnet, daß die Spannungsmittel (7) ein Halbleiterschalter (16) sind und eine Spannungsquelle (9) in Serie mit Source und Drain des Transistors (1) geschaltet ist.

## Revendications

1. Commutateur opto-électronique caractérisé en ce qu'il comprend un détecteur photoconducteur (1) et en ce que des moyens de tension (7) sont connectés audit détecteur photoconducteur (1) de façon à appliquer à celui-ci une tension de polarisation non nulle pour le rendre sensible à un signal optique incident, et une tension de polarisation sensiblement nulle pour le rendre insensible à ce signal optique.

2. Commutateur selon la revendication 1, caractérisé en ce que ledit détecteur photoconducteur est un transistor à effet de champ photosensitif (1) et en ce que lesdits moyens de tension (7) sont tels qu'ils modifient la tension de polarisation entre la source (2) et le drain (5) du transistor (1), de façon à commuter ce transistor entre les états "sensible" et "insensible".

3. Commutateur selon la revendication 2, caractérisé en ce que des moyens (13) sont prévus pour diriger le signal optique sur le canal du transistor.

4. Commutateur selon la revendication 2 ou la revendication 3, caractérisé en ce que lesdits moyens de tension (7) appliquent l'un de deux niveaux de tension différents et prédéterminés (OFF, ON) entre la source et le drain du transistor, le niveau sensiblement nul (OFF) rendant le transistor insensible à un signal optique et le niveau non nul (ON) le rendant sensible à ce signal optique.

5. Commutateur selon l'une quelconque des revendications précédentes, caractérisé en ce que le détecteur est un transistor à effet de champ GaAs.

6. Commutateur selon l'une quelconque des revendications précédentes, caractérisé en ce que les moyens de tension comprennent une source de tension (9) connectée au détecteur et un interrupteur à semi-conducteur (14) connecté en parallèle entre ladite source de tension (9) et la masse.

7. Commutateur selon l'une quelconque des revendications 2 à 5, caractérisé en ce que les moyens de tension comprennent une source de tension (9) et un interrupteur à semi-conducteur (16) connectés en série avec la source et le drain du transistor (1).

FIG. 1

FIG. 2

1

FIG. 3

ISOLATION

70dB

ON

OFF

0.5 MHz

130 MHz

10dB

FREQUENCY

FIG. 4

ISOLATION

80 dB

ON

OFF

0.5MHz

130MHz

10dB

FREQUENCY

"OFF"

"ON" 15

OV

GATING PULSE

14

7

TO LOAD
RESISTOR 6

VOLTAGE SOURCE 9

## FIG. 5

"ON"

"OFF" 17

OV

GATING PULSE

16

7

TO LOAD
RESISTOR 6

VOLTAGE SOURCE 9

## FIG. 6